# EUROPEAN PATENT APPLICATION

(11) **EP 4 131 341 A1**
(43) Date of publication of application: **08.02.2023**
(21) Application number: 21779964.2
(22) Date of filing: 09.02.2021
(51) Int. Cl.: H01L 21/265, H01L 21/66

(54) **METHOD FOR CONTROLLING DONOR CONCENTRATION IN SILICON SINGLE CRYSTAL SUBSTRATE**

(30) Priority: 02.04.2020 JP 2020067011
(71) Applicant: Shin-Etsu Handotai Co., Ltd., Tokyo 100-0004 (JP)
(72) Inventor: TAKENO, Hiroshi, Annaka-shi, Gunma 379-0196 (JP)
(74) Representative: Sonnenhauser, Thomas Martin
(86) International application number: PCT/JP2021/004759
(87) International publication number: WO 2021/199687

(57) **Abstract**

The present invention is a method for controlling a donor concentration in a silicon single crystal substrate in which an oxygen concentration and a carbon concentration in a silicon single crystal substrate whose donor concentration is to be controlled and which is prepared in a preparation step are adjusted based on an acquired correlation such that the donor concentration in the silicon single crystal substrate whose donor concentration is to be controlled reaches a target value after a second heat treatment step. This provides a method for controlling a donor concentration in a silicon single crystal substrate in such a manner to successfully reduce a variation in donor concentration attributable to silicon single crystal substrates and control the donor concentration with high precision.

## Description

### TECHNICAL FIELD

The present invention relates to a method for controlling a donor concentration in a silicon single crystal substrate.

### BACKGROUND ART

To increase speed and reduce loss of IGBT (Insulated Gate Bipolar Transistor) and diode for switching devices, a structure is utilized in which a field stop layer (or buffer layer) is formed on the back surface side of a thin wafer (Patent Document 1). Moreover, in order to have soft recovery characteristics also, a structure is proposed in which a broad buffer layer is formed substantially at the center in a thickness direction of a wafer, too (Patent Document 2).

As the method of forming a buffer layer or a broad buffer layer, there is a method in which donors are formed by proton irradiation and heat treatment. For example, Patent Document 1 discloses a method in which after a wafer is thinned, a buffer layer is formed by proton irradiation and heating (for example, 300°C to 500°C). Meanwhile, Patent Document 2 discloses a method in which a broad buffer layer is formed by proton irradiation at a proton dose of 1×10¹¹ atoms/cm² or more and 1×10¹⁴ atoms/cm² or less and heating at 250°C or more and 500°C or less.

In the method of forming a buffer layer by proton irradiation and heating, a wide buffer layer can also be formed in a deep region in comparison with common cases of buffer layer formation by dopant ion implantation and activation heat treatment. Thus, improvement in device characteristics can be expected. Further, since donors can be formed by heating at low temperature, there is an advantage that problems such as cracking and scratching can be reduced in a process after the wafer is thinned.

Meanwhile, it is known that the concentration of donors formed by proton irradiation and heating is influenced by the concentrations of oxygen and carbon, which are light element impurities in a silicon single crystal substrate. For example, Patent Document 2 states that the oxygen atom concentration in a region where a broad buffer layer is formed by proton irradiation and heating is desirably 1×10¹⁶ atoms/cm³ or more.

Additionally, Patent Document 3 states that to form a region with high donor concentration, the semiconductor substrate may be an MCZ (Magnetic Field Applied Czochralski) substrate, the semiconductor substrate may have an average oxygen concentration of 1.0×10¹⁶/cm³ or more and 1.0×10¹⁸/cm³ or less, or the semiconductor substrate may have an average carbon concentration of 1.0×10¹⁴/cm³ or more and 3.0×10¹⁵/cm³ or less.

Further, Non Patent Document 1 shows trends that the higher the oxygen concentration is, the higher the integrated donor concentration of the field stop layer formed by proton irradiation and heating, and also that the higher the carbon concentration is, the higher the integrated donor concentration.

As mentioned above, the concentration of donors formed by proton irradiation and heating is influenced by the concentrations of oxygen and carbon in a silicon single crystal substrate. Hence, the donor concentration varies depending on the silicon single crystal substrate in some cases.

### CITATION LIST

### PATENT LITERATURE

Patent Document 1: JP 3684962 B2
Patent Document 2: JP 5104314 B2
Patent Document 3: JP 6311840 B2

### NON PATENT LITERATURE

Non Patent Document 1: H. J. Schulze et al., Proceedings of the 2016 28th International Symposium on Power Semiconductor Devices and ICs (ISPSD), p.355.

### SUMMARY OF INVENTION

### TECHNICAL PROBLEM

The method of forming donors by proton irradiation and heating is an effective method for device characteristic improvement and process load reduction. Nevertheless, donors behave in a complex manner depending on the influences of light elements. These make it difficult to precisely control donor concentration.

The known techniques disclose that if the oxygen concentration is a certain value or more, the donor formation ratio by protons is improved, and that the higher the oxygen or carbon concentration, the higher the donor concentration. However, these are not necessarily always true. There are problems that it is difficult to control the donor concentration only with the oxygen concentration or carbon concentration, and the donor concentration varies in some cases.

The present invention has been made in view of the problems as described above. An object of the present invention is to provide a method for controlling a donor concentration in a silicon single crystal substrate in such a manner to successfully reduce a variation in donor concentration attributable to silicon single crystal substrates and control the donor concentration with high precision in a device manufacturing process in which donor concentration is controlled by proton irradiation and heating.

### SOLUTION TO PROBLEM

The present invention has been made to achieve the object, and provides a method for controlling a donor concentration in a silicon single crystal substrate by performing:
a preparation step of preparing a silicon single crystal substrate whose donor concentration is to be controlled;
a second proton irradiation step of irradiating with protons the prepared silicon single crystal substrate; and
a second heat treatment step of heating the silicon single crystal substrate after the second proton irradiation step, so that the donor concentration is controlled,
wherein the method comprises:
   a first proton irradiation step of irradiating with protons a plurality of test silicon single crystal substrates having different oxygen concentrations and carbon concentrations in advance before performing the preparation step;
   a first heat treatment step of heating the plurality of test silicon substrates after the first proton irradiation step;
   a measurement step of measuring donor increments attained in the plurality of test silicon single crystal substrates after the first heat treatment step; and
   a correlation acquisition step of acquiring a correlation between the measured donor increments and products of the oxygen concentrations and the carbon concentrations of the plurality of test silicon substrates,
   wherein an oxygen concentration and a carbon concentration in the silicon single crystal substrate whose donor concentration is to be controlled and which is prepared in the preparation step are adjusted based on the acquired correlation such that the donor concentration in the silicon single crystal substrate whose donor concentration is to be controlled reaches a target value after the second heat treatment step.

According to such a method for controlling a donor concentration in a silicon single crystal substrate, a correlation between donor increments in multiple test silicon single crystal substrates after the first heat treatment step and products of oxygen concentrations and carbon concentrations is obtained in advance from the test silicon single crystal substrates. Based on this correlation, the oxygen concentration and carbon concentration in a silicon single crystal substrate whose donor concentration is to be controlled are adjusted to thereby control the donor concentration. These make it possible to reduce a variation in donor concentration attributable to silicon single crystal substrates and control the donor concentration with high precision.

In this event, preferably, a product of the oxygen concentration and the carbon concentration in the silicon single crystal substrate whose donor concentration is to be controlled and which is prepared in the preparation step is 1×10³² [(atoms/cm³)]² or less, and the second heat treatment step is performed at a heating temperature of 300 to 400°C.

When the products of the oxygen and carbon concentrations are 1×10³² [(atoms/cm³)]² or less and the second heating is performed at the temperature of 300 to 400°C as described above, there is a strong negative correlation between the donor increments and the products of the oxygen and carbon concentrations. Thus, donor concentration variation attributable to silicon single crystal substrates can be further reduced and the donor concentration can be controlled with higher precision by controlling the donor concentration through the adjustment of the oxygen and carbon concentrations of a silicon single crystal substrate whose donor concentration is to be controlled on the basis of the correlation acquired in advance from multiple test silicon single crystal substrates, the correlation being found between the donor increments in the multiple test silicon single crystal substrates after the first heat treatment step and the products of the oxygen and carbon concentrations. The lower limit of the product of the oxygen and carbon concentrations is not particularly limited. In the state of the art, approximately 1×10²⁸ [(atoms/cm³)]² is preferable.

Meanwhile, in this event, preferably a product of the oxygen concentration and the carbon concentration in the silicon single crystal substrate whose donor concentration is to be controlled and which is prepared in the preparation step is 2×10³³ [(atoms/cm³)]² or less, and the second heat treatment step is performed at a heating temperature of 425 to 500°C.

When the products of the oxygen and carbon concentrations are 2×10³³ [(atoms/cm³)]² or less and the second heat treatment step is performed at the heating temperature of 425 to 500°C as described above, there is a strong positive correlation between the donor increments and the products of the oxygen and carbon concentrations. Thus, donor concentration variation attributable to silicon single crystal substrates can be further reduced and the donor concentration can be controlled with higher precision by controlling the donor concentration through the adjustment of the oxygen and carbon concentrations of a silicon single crystal substrate whose donor concentration is to be controlled on the basis of the correlation acquired in advance from multiple test silicon single crystal substrates, the correlation being found between the donor increments in the multiple test silicon single crystal substrates after the first heat treatment step and the products of the oxygen and carbon concentrations.

Additionally, besides the donors formed by the proton irradiation and the heating, oxygen-related thermal donors are formed even in a region not irradiated with the protons, if the oxygen concentration is high. This may result in a problem that electrical resistivity is changed. Accordingly, the product of the oxygen and carbon concentrations is preferably 2×10³³ [(atoms/cm³)]² or less.

Note that even when the products of the oxygen and carbon concentrations exceed 2×10³³ [(atoms/cm³)]², a positive correlation is found between the donor increments and the products of the oxygen and carbon concentrations.

In the second heat treatment step, when the heating temperature is 400 to 425°C, an intermediate correlation is found between the case with the heating temperature of 300 to 400°C and that of 425 to 500°C.

### ADVANTAGEOUS EFFECTS OF INVENTION

As described above, according to the inventive method for controlling a donor concentration in a silicon single crystal substrate, donor concentration variation attributable to silicon single crystal substrates can be reduced by adjusting the oxygen and carbon concentrations of a silicon single crystal substrate, so that the donor concentration can be controlled with high precision. In addition, the present invention makes it possible to control a donor concentration with high precision in controlling a donor concentration in an FZ silicon single crystal substrate in which the product of oxygen and carbon concentrations can be reduced. Thus, the present invention is particularly suitable when a floating-zone (FZ) silicon single crystal substrate is used for a power device.

### BRIEF DESCRIPTION OF DRAWINGS

FIG. 1 is a chart illustrating an example of the inventive method for controlling a donor concentration in a silicon single crystal substrate.
FIG. 2 is a graph illustrating a depth direction distribution of donor increments measured after a treatment at a heating temperature of 350°C in Experimental Example 1 (o marks represent substrates A, △ marks represent substrates B).
FIG. 3 is a graph illustrating a depth direction distribution of donor increments measured after a treatment at a heating temperature of 450°C in Experimental Example 1 (o marks represent substrates A, △ marks represent substrates B).
FIG. 4 is a graph illustrating a relation between integrated donor increments measured in Experimental Example 1 and heating temperatures (o marks represent substrates A, △ marks represent substrates B).
FIG. 5 is a graph illustrating a relation between integrated donor increments measured in Experimental Example 2 and nitrogen concentrations.
FIG. 6 is a graph illustrating a relation between the integrated donor increments measured in Experimental Example 2 and oxygen concentrations.
FIG. 7 is a graph illustrating a relation between the integrated donor increments measured in Experimental Example 2 and carbon concentrations.
FIG. 8 is a graph illustrating a relation between integrated donor increments measured in Experimental Example 2 and Example 1 and products of the oxygen and carbon concentrations.
FIG. 9 is a graph illustrating a relation between integrated donor increments measured in Experimental Example 3 and nitrogen concentrations.
FIG. 10 is a graph illustrating a relation between the integrated donor increments measured in Experimental Example 3 and oxygen concentrations (o marks represent FZ silicon single crystal substrates, □ marks represent MCZ silicon single crystal substrates).
FIG. 11 is a graph illustrating a relation between the integrated donor increments measured in Experimental Example 3 and carbon concentrations (o marks represent FZ silicon single crystal substrates, □ marks represent MCZ silicon single crystal substrates).
FIG. 12 is a graph illustrating a relation between the integrated donor increments measured in Experimental Example 3 and Example 2 and products of the oxygen and carbon concentrations (o marks represent FZ silicon single crystal substrates, □ marks represent MCZ silicon single crystal substrates).
FIG. 13 is a graph illustrating a relation between integrated donor increments measured in Experimental Example 4 and oxygen concentrations (o marks represent FZ silicon single crystal substrates, □ marks represent MCZ silicon single crystal substrates).
FIG. 14 is a graph illustrating a relation between the integrated donor increments measured in Experimental Example 4 and carbon concentrations (o marks represent FZ silicon single crystal substrates, □ marks represent MCZ silicon single crystal substrates).
FIG. 15 is a graph illustrating a relation between the integrated donor increments measured in Experimental Example 4 and products of the oxygen and carbon concentrations (o marks represent FZ silicon single crystal substrates, □ marks represent MCZ silicon single crystal substrates).

### DESCRIPTION OF EMBODIMENTS

Hereinafter, the present invention will be described in detail. However, the present invention is not limited thereto.

As noted above, in the conventional techniques, a donor concentration is controlled by proton irradiation and heating. However, there is such a problem that the donor concentration varies depending on silicon single crystal substrates even when the same proton-irradiation and heating conditions are employed. Moreover, it is disclosed that the higher the oxygen concentration in a silicon single crystal substrate, the higher the concentration of donors formed by proton irradiation and heating, and that the higher the carbon concentration, the higher the donor concentration.

The present inventor has earnestly studied and found that when proton irradiation and heating are performed on silicon single crystal substrates, the relations of donor increment to oxygen and carbon concentrations in the silicon single crystal substrates are not always positive correlations unlike the conventional belief. Further, the inventor has found a strong correlation between donor concentration and product of oxygen and carbon concentrations. These findings have led to the completion of the present invention.

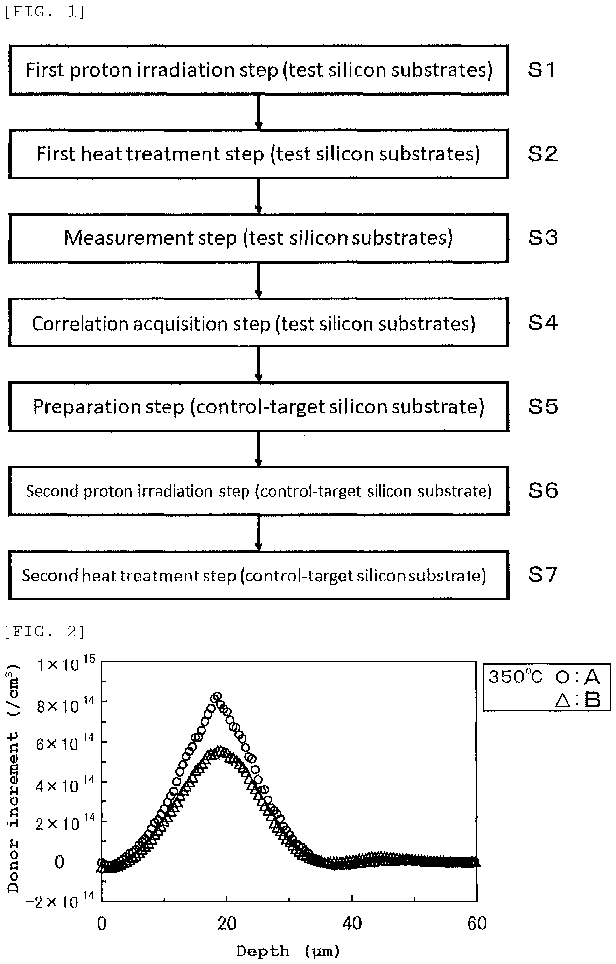

Hereinbelow, the inventive method for controlling a donor concentration in a silicon single crystal substrate will be described with reference to the drawings. Note that silicon single crystal substrates in parentheses in FIG. 1 indicate silicon single crystal substrates treated in the respective steps.

First, multiple test silicon single crystal substrates are prepared. The multiple test silicon single crystal substrates prepared here have different oxygen concentrations and carbon concentrations from one another. Additionally, conditions other than the oxygen and carbon concentrations may be the same as those of a silicon single crystal substrate whose donor concentration is to be actually controlled (control-target silicon single crystal substrate).

Moreover, the method of preparing the test silicon single crystal substrates is not particularly limited in the present invention. For example, the test silicon single crystal substrates can be prepared by: slicing off silicon wafers from a silicon single crystal; performing a chemical etching treatment on the silicon wafers to eliminate the slicing damage; and then performing chemical-mechanical polishing.

### [First Proton Irradiation Step S1]

Next, the multiple test silicon single crystal substrates are irradiated with protons (first proton irradiation step). In this event, before the proton irradiation, an oxide film or the like may be formed on each silicon single crystal substrate. The proton irradiation conditions are desirably the same as proton irradiation conditions of a second proton irradiation step (S6 in FIG. 1) in a manufacturing process of a control-target semiconductor device which will be described later in detail. Additionally, in a case where an absorber is used to adjust the range of protons, the material and thickness of the absorber are also desirably the same as those in the second proton irradiation step (S6 in FIG. 1).

### [First Heat Treatment Step S2]

Next, a first heat treatment step is performed to heat the multiple test silicon substrates after the first proton irradiation. The heating conditions are desirably the same as heating conditions of a second heat treatment step (S7 in FIG. 1) in the manufacturing process of a control-target semiconductor device which will be described later in detail.

### [Measurement Step S3]

Next, a measurement step is performed to measure the concentration of donors formed (donor increment) in the multiple test silicon single crystal substrates after the first heat treatment step. The method of measuring the donor concentration is not particularly limited. For example, spreading resistance measurement method (SR method) can be employed.

For example, in the SR method, a sample is obliquely polished, two probes are brought into contact with the polished surface to measure the spreading resistance between the probes, and a specific resistance is calculated from the measured spreading resistance by using the calibration curve. Then, based on a known relation between specific resistances and donor concentrations, a donor concentration is obtained from the calculated specific resistance. In this manner, a depth direction distribution of donor concentrations is obtained.

Next, a donor concentration in a matrix (a deep region where the donor concentration is substantially uniform) is subtracted from donor concentrations (N_{D}(x)) measured at depths x. Thereby, donor increments (ΔN_{D}(x)) at the depths x are obtained. Then, as a characteristic value of the donor increments, an integrated donor increment can be determined by performing integration calculation on the donor increments in the depth direction. Alternatively, as a characteristic value of the donor increments, a maximum donor increment can be determined which is located at a depth position where the donor increment is the maximum in the depth direction.

### [Correlation Acquisition Step S4]

Next, a correlation acquisition step is performed (S4 in FIG. 1). In the correlation acquisition step, the donor increments measured in the measurement step (S3 in FIG. 1) are associated with products of the oxygen concentrations and the carbon concentrations of the multiple test silicon single crystal substrates to acquire a correlation between the donor increments and the products of the oxygen and carbon concentrations.

### [Preparation Step S5]

Next, based on the correlation acquired as described above, an oxygen concentration and a carbon concentration of a silicon single crystal substrate prepared in a preparation step are adjusted such that a donor concentration in the silicon single crystal substrate after a heat treatment step reaches a target value (S5 in FIG. 1).

In this event, in a case where a second heat treatment step to be described later is performed at a heating temperature of 300 to 400°C, the products of the oxygen and carbon concentrations in the test silicon single crystal substrates are desirably 1×10³² [(atoms/cm³)]² or less. The lower limit of the products of the oxygen and carbon concentrations is not particularly limited. In the state of the art, 1×10²⁸ [(atoms/cm³)]² or so is preferable.

Meanwhile, in this event, when the second heat treatment step to be described later is performed at a heating temperature of 425 to 500°C, a product of the oxygen and carbon concentrations in the test silicon single crystal substrate is desirably 2×10³³ [(atoms/cm³)]² or less. The lower limit of the product of the oxygen and carbon concentrations is not particularly limited. In the state of the art, 1×10²⁸ [(atoms/cm³)]² or so is preferable.

The method of adjusting the oxygen and carbon concentrations of the control-target silicon single crystal substrate to be prepared is not particularly limited in the present invention. For example, it is possible to employ methods of adjusting raw materials in growing a silicon single crystal or adjusting the growth conditions, or other methods. Further, the oxygen and carbon concentrations of the silicon single crystal substrate can be adjusted by heating the silicon single crystal substrate to inwardly diffuse oxygen and carbon into the silicon single crystal substrate. Alternatively, the oxygen and carbon concentrations of the silicon single crystal substrate can be adjusted by implanting oxygen and carbon ions from the surface of the silicon single crystal substrate.

### [Second Proton Irradiation Step S6]

Next, the prepared control-target silicon single crystal substrate is subjected to the second proton irradiation step (S6 in FIG. 1). The conditions of the proton irradiation performed here are preferably the same conditions as in the first proton irradiation step (S1 in FIG. 1). In the proton irradiations, the acceleration voltage can be, for example, 8 MV, and the proton dose can be, for example, 2×10¹⁴ atoms/cm².

### [Second Heat Treatment Step S7]

Next, the proton-irradiated control-target silicon single crystal substrate is subjected to the second heat treatment step (S7 in FIG. 1). The conditions of the heat treatment performed here are preferably the same conditions as in the first heat treatment step (S2 in FIG. 1). The heating conditions can be: for example, a treatment time of 20 minutes to 3 hours, and an atmosphere of nitrogen, oxygen, hydrogen, or the like.

The inventive method for controlling a donor concentration as described above makes it possible to reduce a variation in donor concentration attributable to silicon single crystal substrates, and to thereby control the donor concentration with high precision.

In the present invention, the reason of employing the method for controlling a donor concentration in a silicon single crystal substrate as described above in order to reduce donor concentration variation attributable to silicon single crystal substrates to control the donor concentration with high precision is based on findings obtained by experiments as follows.

### (Experimental Example 1)

Two types of FZ silicon single crystal substrates (substrates A, substrates B) were prepared from silicon single crystals grown by the floating zone method (FZ method). Both of the substrates were phosphorus-doped N type and had a dopant concentration of 7×10¹³ to 8×10¹³ atoms/cm³.

The substrates A were produced from a silicon single crystal that had been grown by the FZ method using a common polycrystalline silicon ingot as the raw material. The oxygen concentration was 2.0×10¹⁵ atoms/cm³, the carbon concentration was 8.9×10¹⁴ atoms/cm³, and the nitrogen concentration was 1.2×10¹⁵ atoms/cm³.

The substrates B were produced from a silicon single crystal that had been grown by the FZ method using a silicon single crystal ingot having been grown by the CZ method as the raw material. The oxygen concentration was 1.2×10¹⁶ atoms/cm³, the carbon concentration was 1.0×10¹⁵ atoms/cm³, and the nitrogen concentration was 1.5×10¹⁵ atoms/cm³.

The oxygen concentrations were measured by an infrared absorption method (using the conversion factor specified by JEIDA). The carbon and nitrogen concentrations were measured by secondary ion mass spectrometry (SIMS).

Next, the prepared silicon single crystal substrates were irradiated with protons. In this event, the proton dose was 2×10¹⁴ atoms/cm², and the proton acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 µm.

Next, the silicon single crystal substrates after the proton irradiation were heated. In this event, the heating conditions were such that the temperatures were set within a range of 300 to 550°C, the time was 60 minutes, and the atmosphere was nitrogen atmosphere.

Next, the depth direction distribution of donor concentrations in each of the heated silicon single crystal substrates was measured by spreading resistance measurement method (SR method).

Table 1 shows the conditions in Experimental Example 1.

**[Table 1]**

| | Substrates A | Substrates B |
|---|---|---|
| Substrate growth method | FZ method | |
| Dopant type | phosphorus (N type) | |
| Dopant concentration [atoms/cm³] | 7×10¹³ to 8×10¹³ | |
| Raw-material silicon | polycrystalline silicon ingot | silicon single crystal ingot grown by CZ method |
| Oxygen concentration [atoms/cm³] | 2.0×10¹⁵ | 1.2×10¹⁶ |
| Carbon concentration [atoms/cm³] | 8.9×10¹⁴ | 1.0×10¹⁵ |
| Nitrogen concentration [atoms/cm³] | 1.2×10¹⁵ | 1.5×10¹⁵ |
| Proton dose [atoms/cm³] | 2×10¹⁴ | |
| Acceleration voltage [MV] | 8 | |
| Proton range [um] | about 15 | |
| Absorber material | aluminum foils | |
| Total absorber thickness [µm] | about 410 | |
| Heating temperature [°C] | 300 to 550 | |
| Heating time [min.] | 60 | |
| Atmosphere | nitrogen atmosphere | |
| Measurement of depth direction distribution of donor concentration | spreading resistance measurement method (SR method) | |

Next, a donor concentration (average value of donor concentrations at depths from approximately 60 to 70 µm) in a matrix (deep region where the donor concentration was substantially uniform) was subtracted from the donor concentrations (N_{D}(x)) measured at depths x. Thereby, donor increments (ΔN_{D}(x)) at the depths x were obtained.

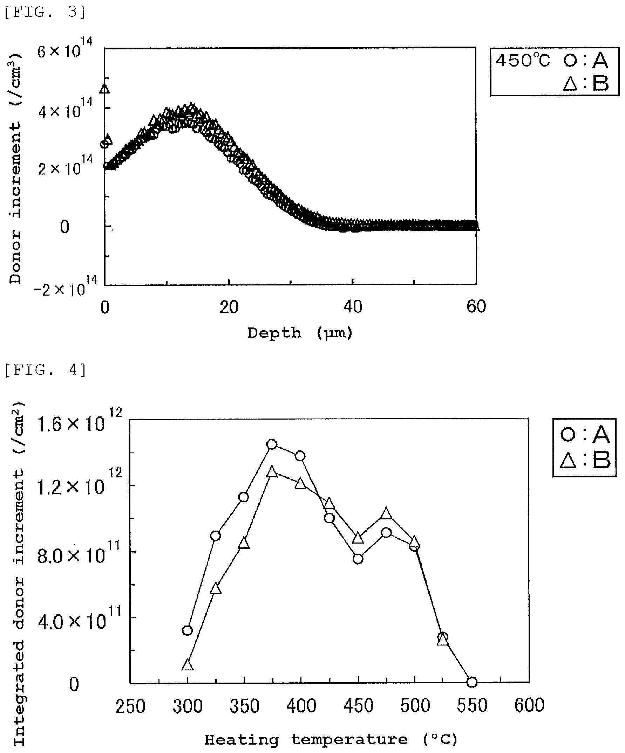

FIGs. 2 and 3 show examples of depth direction distributions of donor increments obtained in this manner. FIG. 2 shows a case where the heating temperature was 350°C. FIG. 3 shows a case where the heating temperature was 450°C. In FIGs. 2 and 3, the difference in marks indicates the difference in the substrates. o represents the substrate A, and Δ represents the substrate B.

Next, an integrated donor increment was obtained by integrating the donor increments in the depth direction. FIG. 4 shows a relation between integrated donor increments obtained in this manner and the heating temperatures. In FIG. 4, the difference in marks indicates the difference in the substrates. o represents the substrate A, and △ represents the substrate B.

The result in FIG. 4 reveals that the integrated donor concentration increased in a heating-temperature range of 300 to 525°C. Moreover, since peaks were observed around 375°C and around 475°C, at least two types of donors are presumably formed depending on the heating temperature. Further, the integrated donor increments of the substrates A were higher in the heating-temperature range of 300 to 400°C, whereas those of the substrates B were higher in the heating-temperature range of 425 to 500°C. This reveals that the difference in donor increment due to the difference in the silicon single crystal substrates varies depending on the heating temperature.

### (Experimental Example 2)

Multiple FZ silicon single crystal substrates having different oxygen concentrations and carbon concentrations were prepared. The multiple FZ silicon single crystal substrates included ones produced from a silicon single crystal grown by the FZ method using a common polycrystalline silicon ingot as the raw material, and ones produced from a silicon single crystal grown by the FZ method using a silicon single crystal ingot having been grown by the CZ method as the raw material. The dopant type, dopant concentration, oxygen concentration, carbon concentration, nitrogen concentration, diameter, and crystal plane orientation thereof were as follows.
dopant type/concentration: phosphorus/6.0×10¹³ to 8.7×10¹³ atoms/cm³,
oxygen concentration: 2.0×10¹⁵ to 2.1×10¹⁶ atoms/cm³,
carbon concentration: 6.4×10¹⁴ to 4.8×10¹⁵ atoms/cm³,
nitrogen concentration: 3.6×10¹⁴ to 3.5×10¹⁵ atoms/cm³,
diameter: 200 mm,
crystal plane orientation: (100).

The oxygen concentration was measured by an infrared absorption method (using the conversion factor specified by JEIDA). The carbon and nitrogen concentrations were measured by secondary ion mass spectrometry (SIMS).

Next, the prepared silicon single crystal substrates were irradiated with protons. In this event, the proton dose was 2×10¹⁴ atoms/cm², and the proton acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 um.

Next, the silicon single crystal substrates after the proton irradiation were heated. In this event, the heating conditions were such that the temperature was 350°C, the time was 60 minutes, and the atmosphere was nitrogen atmosphere.

Next, the depth direction distribution of donor concentrations in each of the heated silicon single crystal substrates was measured by spreading resistance measurement method (SR method).

Table 2 shows the conditions in Experimental Example 2.

**[Table 2]**

| Substrate growth method | FZ method |
|---|---|
| Dopant type | phosphorus |
| Dopant concentration [atoms/cm³] | 6.0×10¹³ to 8.7×10¹³ |
| Raw-material silicon | polycrystalline silicon ingot, and silicon single crystal ingot grown by CZ method |
| Oxygen concentration [atoms/cm³] | 2.0×10¹⁵ to 2.1×10¹⁶ |
| Carbon concentration [atoms/cm³] | 6.4×10¹⁴ to 4.8×10¹⁵ |
| Nitrogen concentration [atoms/cm³] | 3.6×10¹⁴ to 3.5×10¹⁵ |
| Diameter [mm] | 200 |
| Crystal orientation | (100) |
| Proton dose [atoms/cm²] | 2×10¹⁴ |
| Acceleration voltage [MV] | 8 |
| Proton range [µm] | about 15 |
| Absorber material | aluminum foils |
| Total absorber thickness [µm] | about 410 |
| Heating temperature [°C] | 350 |
| Heating time [min.] | 60 |
| Atmosphere | nitrogen atmosphere |
| Measurement of depth direction distribution of donor concentration | spreading resistance measurement method (SR method) |

Next, a donor concentration (average value of donor concentrations at depths from approximately 60 to 70 µm) in a matrix (deep region where the donor concentration was substantially uniform) was subtracted from the donor concentrations (N_{D}(x)) measured at depths x. Thereby, donor increments (ΔN_{D}(x)) at the depths x were obtained.

Next, an integrated donor increment was obtained by integrating the donor increments in the depth direction. Relations of such integrated donor increments to the nitrogen concentrations, oxygen concentrations, and carbon concentrations in the silicon single crystal substrates were examined.

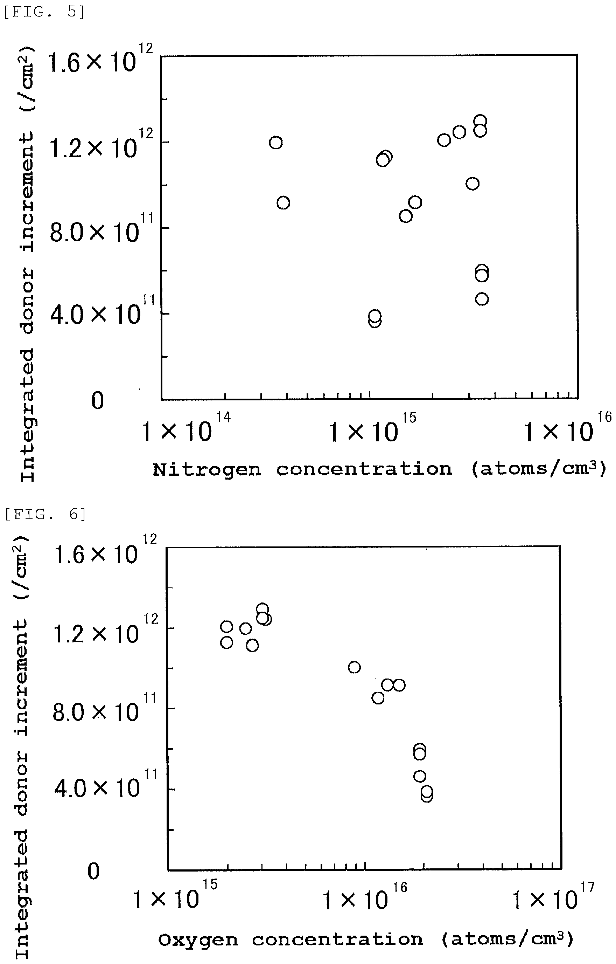

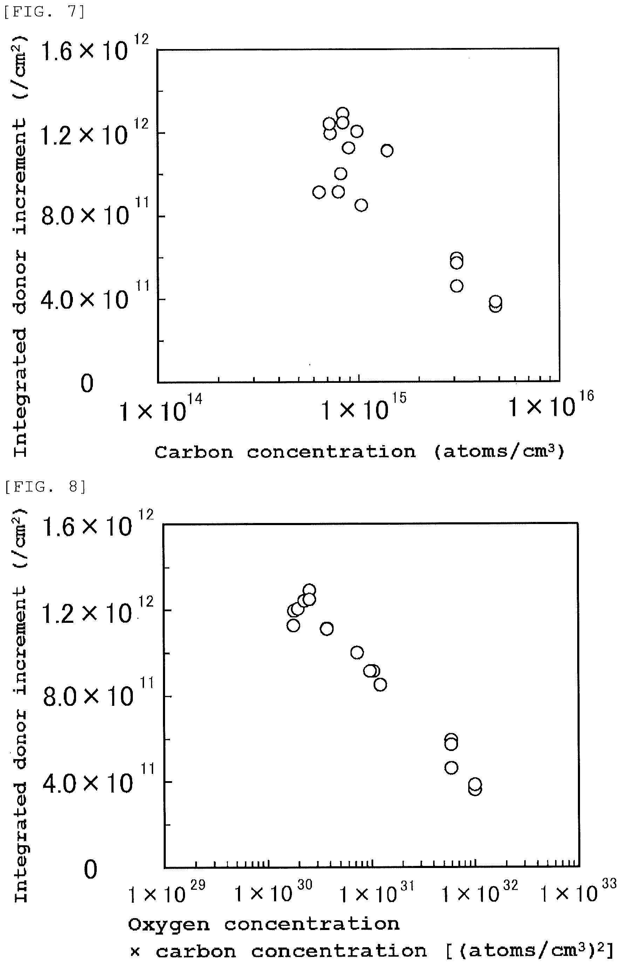

The integrated donor increments had a relation to the nitrogen concentrations shown in FIG. 5, a relation to the oxygen concentrations shown in FIG. 6, a relation to the carbon concentrations shown in FIG. 7, and a relation to products of the oxygen concentrations and the carbon concentrations shown in FIG. 8.

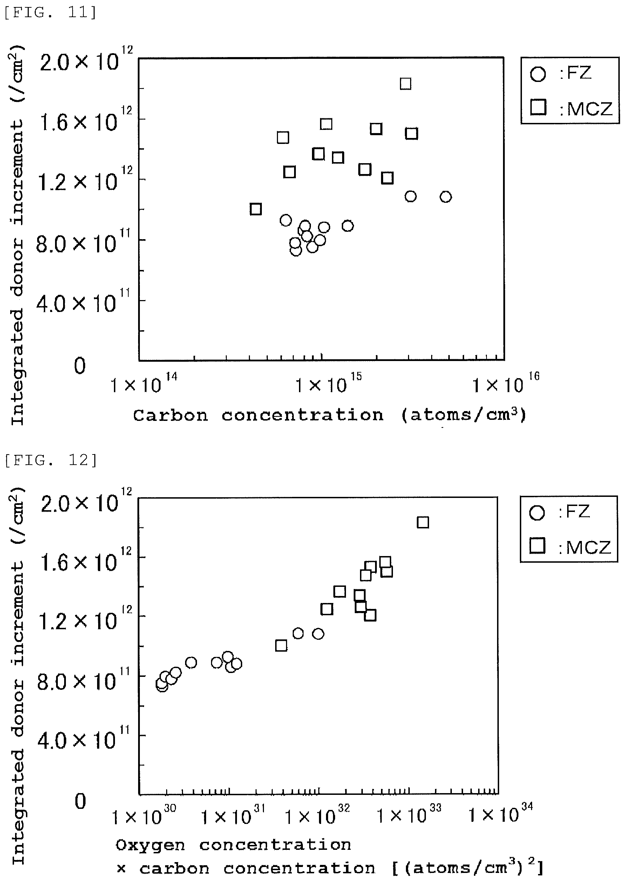

The result in FIG. 5 reveals that the integrated donor increment does not depend on the nitrogen concentration. Meanwhile, the results in FIGs. 6 and 7 reveal such trends that the higher the oxygen concentration, the lower the integrated donor increment, and that the higher the carbon concentration, the lower the integrated donor increment, but the variation was large. Further, as shown in FIG. 8, a strong negative correlation is revealed between the integrated donor increments and the products of the oxygen concentrations and the carbon concentrations. In other words, this correlation is opposite to a case where the heating temperature was 450°C as shown in FIG. 12, which will be described later.

It can be seen from the result in FIG. 4 that the negative correlation between the products of the oxygen and carbon concentrations (substrates A<substrates B) and the integrated donor increments (substrates A>substrates B) was found in the heating-temperature range of 300 to 400°C. Thus, based on the results in FIGs. 4 and 8, at the heating temperature of 300 to 400°C, the donor increments have a strong negative correlation with the products of the oxygen and carbon concentrations, given that the products of the oxygen and carbon concentrations are at least 1×10³² [(atoms/cm³)]² or less. It was revealed that a donor concentration can be controlled with high precision by adjusting oxygen and carbon concentrations in a silicon single crystal substrate based on this correlation.

### (Experimental Example 3)

FZ silicon single crystal substrates were prepared as in Experimental Example 2. In addition, multiple MCZ silicon single crystal substrates having different oxygen concentrations and carbon concentrations were also prepared. The multiple MCZ silicon single crystal substrates were produced from a silicon single crystal having been grown by the magnetic field applied Czochralski method (MCZ method). The dopant type, dopant concentration, oxygen concentration, carbon concentration, diameter, and crystal plane orientation thereof were as follows, but nitrogen was not contained.
dopant type/concentration: phosphorus/7.4×10¹³ to 1.4×10¹⁴ atoms/cm³,
oxygen concentration: 8.8×10¹⁶ to 5.5×10¹⁷ atoms/cm³,
carbon concentration: 4.4×10¹⁴ to 3.1×10¹⁵ atoms/cm³,
diameter: 200 mm,
crystal plane orientation: (100).

The oxygen concentration was measured by an infrared absorption method (using the conversion factor specified by JEIDA). The carbon concentration was measured by secondary ion mass spectrometry (SIMS).

Next, the prepared silicon single crystal substrates were irradiated with protons. In this event, the proton dose was 2×10¹⁴ atoms/cm², and the proton acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 µm.

Next, the silicon single crystal substrates after the proton irradiation were heated. In this event, the heating conditions were such that the temperature was 450°C, the time was 60 minutes, and the atmosphere was nitrogen atmosphere.

Next, the depth direction distribution of donor concentrations in each of the heated silicon single crystal substrates was measured by spreading resistance measurement method (SR method).

Table 3 shows the conditions in Experimental Example 3, including the conditions of the FZ silicon single crystal substrates as in Experimental Example 2.

**[Table 3]**

| | Substrates as in Experimental Example 2 | Experimental Example 3 |
|---|---|---|
| Substrate growth method | FZ method | MCZ method |
| Dopant type | phosphorus | phosphorus |
| Dopant concentration [atoms/cm³] | 6.0×10¹³ to 8.7×10¹³ | 7.4×10¹³ to 1.4×10¹⁴ |
| Raw-material silicon | polycrystalline silicon ingot, and silicon single crystal ingot grown by CZ method | polycrystalline silicon |
| Oxygen concentration [atoms/cm³] | 2.0×10¹⁵ to 2.1×10¹⁶ | 8.8×10¹⁶ to 5.5×10¹⁷ |
| Carbon concentration [atoms/cm³] | 6.4×10¹⁴ to 4.8×10¹⁵ | 4.4×10¹⁴ to 3.1×10¹⁵ |
| Nitrogen concentration [atoms/cm³] | 3.6×10¹⁴ to 3.5×10¹⁵ | none |
| Diameter [mm] | 200 | 200 |
| Crystal orientation | (100) | (100) |
| Proton dose [atoms/cm²] | 2×10¹⁴ | |
| Acceleration voltage [MV] | 8 | |
| Proton range [µm] | about 15 | |
| Absorber material | aluminum foils | |
| Total absorber thickness [µm] | about 410 | |
| Heating temperature [°C] | 450 | |
| Heating time [min.] | 60 | |
| Atmosphere | nitrogen atmosphere | |
| Measurement of depth direction distribution of donor concentration | spreading resistance measurement method (SR method) | |

Next, a donor concentration (average value of donor concentrations at depths from approximately 60 to 70 µm) in a matrix (deep region where the donor concentration was substantially uniform) was subtracted from the donor concentrations (N_{D}(x)) measured at depths x. Thereby, donor increments (ΔN_{D}(x)) at the depths x were obtained.

Next, an integrated donor increment was obtained by integrating the donor increments in the depth direction. Relations of such integrated donor increments to the nitrogen concentrations, oxygen concentrations, and carbon concentrations in the silicon single crystal substrates were examined.

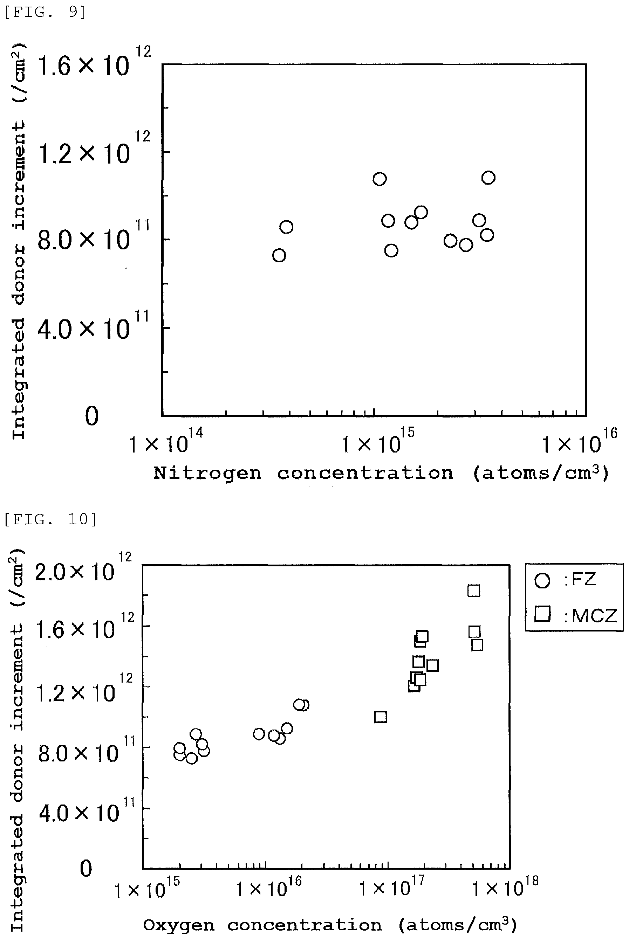

The integrated donor increments had a relation to the nitrogen concentrations shown in FIG. 9, a relation to the oxygen concentrations shown in FIG. 10, a relation to the carbon concentrations shown in FIG. 11, and a relation to products of the oxygen concentrations and the carbon concentrations shown in FIG. 12. In FIGs. 10 to 12, the difference in marks indicates the difference in substrate types. o represents the FZ silicon single crystal substrate, and □ represents the MCZ silicon single crystal substrate.

The result in FIG. 9 reveals that the integrated donor increment does not depend on the nitrogen concentration. Meanwhile, the results in FIGs. 10 and 11 reveal such trends that the higher the oxygen concentration, the higher the integrated donor increment, and that the higher the carbon concentration, the higher the integrated donor increment, but the variation was large. Further, as shown in FIG. 12, a positive correlation is revealed between the integrated donor increments and the products of the oxygen concentrations and the carbon concentrations. In other words, this correlation is opposite to the case where the heating temperature was 350°C as shown in FIG. 8.

It can be seen from the result in FIG. 4 that the positive correlation between the products of the oxygen and carbon concentrations (substrates A<substrates B) and the integrated donor increments (substrates A<substrates B) was found in the heating-temperature range of 425 to 500°C. Thus, based on the results in FIGs. 4 and 12, at the heating temperature of 425 to 500°C, the donor increments have a positive correlation with the products of the oxygen and carbon concentrations, given that the products of the oxygen and carbon concentrations are at least 2×10³³ [(atoms/cm³)]² or less. It was revealed that a donor concentration can be controlled with high precision by adjusting oxygen and carbon concentrations in a silicon single crystal substrate based on this correlation.

### (Experimental Example 4)

Multiple MCZ silicon single crystal substrates having different oxygen concentrations and carbon concentrations were prepared. The multiple MCZ silicon single crystal substrates were produced from a silicon single crystal ingot having been grown by the magnetic field applied Czochralski method (MCZ method). The dopant type, dopant concentration, oxygen concentration, carbon concentration, diameter, and crystal plane orientation thereof were as follows.
dopant type/concentration: phosphorus/7.4×10¹³ to 1.4×10¹⁴ atoms/cm³,
oxygen concentration: 8.8×10¹⁶ to 5.5×10¹⁷ atoms/cm³,
carbon concentration: 4.4×10¹⁴ to 3.1×10¹⁵ atoms/cm³,
diameter: 200 mm,
crystal plane orientation: (100).

The oxygen concentration was measured by an infrared absorption method (using the conversion factor specified by JEIDA). The carbon concentration was measured by secondary ion mass spectrometry (SIMS).

Next, the prepared silicon single crystal substrates were irradiated with protons. In this event, the proton dose was 2×10¹⁴ atoms/cm², and the proton acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 µm.

Next, the silicon single crystal substrates after the proton irradiation were heated. In this event, the heating conditions were such that the temperature was 350°C, the time was 60 minutes, and the atmosphere was nitrogen atmosphere.

Next, the depth direction distribution of donor concentrations in each of the heated silicon single crystal substrates was measured by spreading resistance measurement method (SR method).

Table 4 shows the conditions in Experimental Example 4.

**[Table 4]**

| Substrate growth method | MCZ method |
|---|---|
| Dopant type | phosphorus |
| Dopant concentration [atoms/cm³] | 7.4×10¹³ to 1.4×10¹⁴ |
| Raw-material silicon | polycrystalline silicon |
| Oxygen concentration [atoms/cm³] | 8.8×10¹⁶ to 5.5×10¹⁷ |
| Carbon concentration [atoms/cm³] | 4.4×10¹⁴ to 3.1×10¹⁵ |
| Diameter [mm] | 200 |
| Crystal orientation | (100) |
| Proton dose [atoms/cm³] | 2×10¹⁴ |
| Acceleration voltage [MV] | 8 |
| Proton range [µm] | about 15 |
| Absorber material | aluminum foils |
| Total absorber thickness [µm] | about 410 |
| Heating temperature [°C] | 350 |
| Heating time [min.] | 60 |
| Atmosphere | nitrogen atmosphere |
| Measurement of depth direction distribution of donor concentration | spreading resistance measurement method (SR method) |

Next, a donor concentration (average value of donor concentrations at depths from approximately 60 to 70 µm) in a matrix (deep region where the donor concentration was substantially uniform) was subtracted from the donor concentrations (N_{D}(x)) measured at depths x. Thereby, donor increments (ΔN_{D}(x)) at the depths x were obtained.

Next, an integrated donor increment was obtained by integrating the donor increments in the depth direction. Relations of such integrated donor increments to the oxygen concentrations and carbon concentrations in the silicon single crystal substrates were examined.

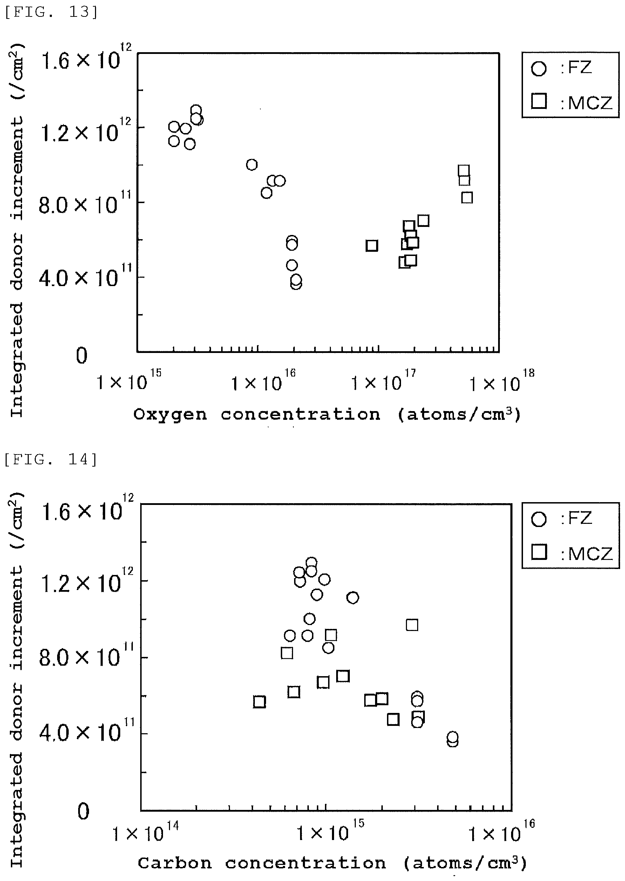

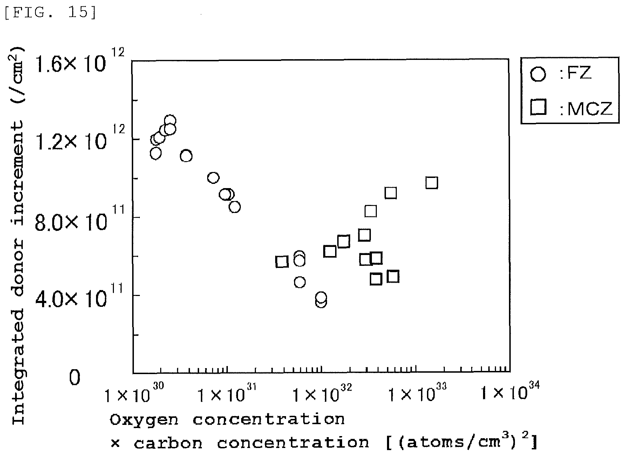

The integrated donor increments had a relation to the oxygen concentrations shown in FIG. 13, a relation to the carbon concentrations shown in FIG. 14, and a relation to products of the oxygen concentrations and the carbon concentrations shown in FIG. 15. FIGs. 13 to 15 also include the data shown in FIGs. 6 to 8, respectively. In FIGs. 13 to 15, the difference in marks indicates the difference in substrate types. o represents the FZ silicon single crystal substrate, and □ represents the MCZ silicon single crystal substrate.

The result in FIG. 15 reveals that in the case where the heating temperature is 350°C, the correlation between the integrated donor increments and the products of the oxygen concentrations and the carbon concentrations changes from the position where the product of the oxygen and carbon concentrations is 1×10³² [(atoms/cm³)]². Moreover, the comparison between FIG. 13 and FIG. 15 reveals that if the product of the oxygen and carbon concentrations exceeds 1×10³² [(atoms/cm³)]², the integrated donor increments have a stronger correlation with the oxygen concentrations than a correlation with the products of the oxygen and carbon concentrations.

It is not exactly known why the donor increments caused by proton irradiation and heating have complicated relations to the oxygen and carbon concentrations in the silicon single crystal substrates and the correlation varies depending on the heating temperature as described above. The reasons are conceivably as follows.

The mechanism of donor formation by proton irradiation and heating is conceivably as follows. When a silicon single crystal substrate is irradiated with protons, hydrogen is introduced; simultaneously, a silicon atom at a lattice position is flicked out, and interstitial silicon (hereinafter referred to as I) and vacancy (hereinafter referred to as V) which is an empty shell thereof are produced. The excessively produced I or V is unstable when it is alone, so that they recombine (V+I→0), clustering of I's or V's occurs, or they react with a light element impurity such as oxygen or carbon contained in the silicon single crystal substrate to form a composite. Additionally, the cluster of I's or V's or the composite of I or V with a light element impurity combines with hydrogen by proton irradiation and heating, so that donors are formed conceivably. From these, it is presumed that multiple types of donors are formed by proton irradiation and heating, and that the types and concentrations vary depending on the concentrations of light element impurities in the silicon single crystal substrate and on the heating temperature.

Meanwhile, if damage by proton irradiation remains after heating, the dopants are inactivated, or the carrier mobility is lowered, so that effective donor concentration may be lowered. The irradiation damage by the proton irradiation is unlikely to recover if the heating temperature is low. Moreover, the irradiation damage is unlikely to recover if the oxygen concentration and carbon concentration in a silicon single crystal substrate are high. In the case where the heating temperature after proton irradiation is low, if the oxygen concentration and carbon concentration in the silicon single crystal substrate are high, the effective donor concentration is lowered due to the remaining irradiation damage, but oxygen- and carbon-related donor concentration attained by proton irradiation and heating is increased.

Hence, the following are conceivable regarding the correlations between the integrated donor increments and the products of the oxygen and carbon concentrations as shown in FIG. 15: if the product of the oxygen and carbon concentrations is 1×10³² [(atoms/cm³)]² or less, decrease in the effective donor concentration due to the remaining irradiation damage becomes dominant, resulting in a negative correlation; meanwhile, if the product of the oxygen and carbon concentrations exceeds 1×10³² [(atoms/cm³)]², the donor concentration attained by proton irradiation and heating and influenced by oxygen and carbon becomes dominant, resulting in a positive correlation. If the heating temperature after proton irradiation is high, the irradiation damage by the proton irradiation is likely to recover, and the decrease in the effective donor concentration due to the remaining irradiation damage is suppressed, so that the donor concentration influenced by oxygen or carbon becomes dominant. This conceivably results in positive correlation over wide ranges of oxygen and carbon concentrations.

### EXAMPLE

Hereinafter, the present invention will be described more specifically with reference to Examples and Comparative Examples. However, the present invention is not limited thereto.

### (Example 1)

As shown in FIG. 1, the donor concentration in a silicon single crystal substrate was controlled by the inventive method for controlling a donor concentration. In this event, the target value of the donor concentration in a silicon single crystal substrate whose donor concentration was to be controlled was set such that the integrated donor increment was controlled to be approximately 8×10¹¹/cm², which was measured as in Experimental Examples.

### [First Proton Irradiation Step S1 to Measurement Step S3]

First, multiple test silicon single crystal substrates having different oxygen concentrations and carbon concentrations were irradiated with protons and then heated. The integrated donor increments in the multiple test silicon single crystal substrates were measured. The test silicon single crystal substrates had been produced from a silicon single crystal grown by the FZ method.

In this event, the proton dose was 2×10¹⁴ atoms/cm², and the acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 um. Further, in this event, the heating temperature was 350°C, the time was 60 minutes, and the atmosphere was nitrogen atmosphere. Furthermore, in this event, the integrated donor increments were measured by employing the same procedure as in Experimental Examples.

### [Correlation Acquisition Step S4]

Next, in the correlation acquisition step, a correlation between the integrated donor increments and products of the oxygen and carbon concentrations was acquired, which was substantially the same as that in FIG. 8.

### [Preparation Step S5]

Next, based on the correlation, oxygen and carbon concentrations of a silicon single crystal substrate (control-target substrate) prepared in the preparation step were adjusted such that the integrated donor increment of the silicon single crystal substrate would reach the target value (approximately 8×10¹¹/cm²) after the second heat treatment step. In this event, the prepared silicon single crystal substrate had been produced from a silicon single crystal grown by the FZ method using a silicon single crystal ingot having been grown by the CZ method as the raw material. The oxygen concentration was adjusted to 1.2×10¹⁶ atoms/cm³, and the carbon concentration was adjusted to 1.0×10¹⁵ atoms/cm³.

### [Second Proton Irradiation Step S6 to Second Heat Treatment Step S7]

Then, the silicon single crystal substrate prepared in the preparation step was irradiated with protons (second proton irradiation step). In this event, the proton dose was 2×10¹⁴ atoms/cm², and the proton acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 µm.

Next, the proton-irradiated silicon single crystal substrate was heated (second heat treatment step). In this event, the heating temperature was 350°C, the time was 60 minutes, and the atmosphere was nitrogen atmosphere.

As a result of measuring the integrated donor increment after the heating, the integrated donor increment of the silicon single crystal substrate was 8.4×10¹¹/cm². Thus, it was confirmed in Example 1 that the donor concentration of the target value was obtained by adjusting the oxygen and carbon concentrations of the silicon single crystal substrate.

### (Example 2)

As shown in FIG. 1, the donor concentration in a silicon single crystal substrate was controlled by the inventive method for controlling a donor concentration. In this event, the target value of the donor concentration in a silicon single crystal substrate whose donor concentration was to be controlled was set such that the integrated donor increment was controlled to be approximately 1.2×10¹²/cm², which was measured as in Experimental Examples.

### [First Proton Irradiation Step S1 to Measurement Step S3]

First, multiple test silicon single crystal substrates having different oxygen concentrations and carbon concentrations were irradiated with protons and then heated. The integrated donor increments in the multiple test silicon single crystal substrates were measured. The multiple test silicon single crystal substrates included FZ silicon single crystal substrates and MCZ silicon single crystal substrates.

In this event, the proton dose was 2×10¹⁹ atoms/cm², and the acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 µm. Further, in this event, the heating temperature was 450°C, the time was 60 minutes, and the atmosphere was nitrogen atmosphere. Furthermore, in this event, the integrated donor increments were measured by employing the same procedure as in Experimental Examples.

### [Correlation Acquisition Step S4]

Next, in the correlation acquisition step, a correlation between the integrated donor increments and products of the oxygen and carbon concentrations was acquired, which was substantially the same as that in FIG. 12.

### [Preparation Step S5]

Next, based on the correlation, oxygen and carbon concentrations of a silicon single crystal substrate prepared in the preparation step were adjusted such that the integrated donor increment of the silicon single crystal substrate (control-target substrate) would reach the target value (approximately 1.2×10¹²/cm²) after the second heat treatment step. In this event, the prepared silicon single crystal substrate had been produced from a silicon single crystal grown by the MCZ method. The oxygen concentration was adjusted to 1.9×10¹⁷ atoms/cm³, and the carbon concentration was adjusted to 6.7×10¹⁴ atoms/cm³.

### [Second Proton Irradiation Step S6 to Second Heat Treatment Step S7]

Then, the silicon single crystal substrate prepared in the preparation step was irradiated with protons (second proton irradiation step). In this event, the proton dose was 2×10¹⁴ atoms/cm², and the proton acceleration voltage was 8 MV. Moreover, in order to achieve the proton range of approximately 15 µm, multiple aluminum foils were placed as an absorber during the proton irradiation on the upstream side of the silicon single crystal substrate such that the foils had a total thickness of approximately 410 µm.

Next, the proton-irradiated silicon single crystal substrate was heated (second heat treatment step). In this event, the heating temperature was 450°C, the time was 60 minutes, and the atmosphere was nitrogen atmosphere.

As a result of measuring the integrated donor increment after the heating, the integrated donor increment of the silicon single crystal substrate was 1.2×10¹²/cm². Thus, it was confirmed in Example 2 that the donor concentration of the target value was obtained by adjusting the oxygen and carbon concentrations of the silicon single crystal substrate.

### (Comparative Example 1)

The donor concentration of a silicon single crystal substrate was controlled under the same conditions as in Example 1, except that the oxygen and carbon concentrations of the prepared silicon single crystal substrate (control-target substrate) were not adjusted based on the correlation acquired using test silicon single crystal substrates.

In this event, the prepared silicon single crystal substrate had been produced from a silicon single crystal grown by the FZ method using a common polycrystalline silicon ingot as the raw material. The oxygen concentration was adjusted to 2.0×10¹⁵ atoms/cm³, and the carbon concentration was adjusted to 9.8×10¹⁴ atoms/cm³.

The prepared silicon single crystal substrate was irradiated with protons and heated under the same conditions as in Example 1. The integrated donor increment was measured by employing the same procedure as in Example 1. As a result, the integrated donor increment was 1.2×10¹²/cm².

Thus, it was found that although the proton irradiation conditions and the heating conditions in Comparative Example 1 were the same conditions as in Example 1, the value of the integrated donor increment of the silicon single crystal substrate was quite different from the target value of approximately 8×10¹¹/cm².

### (Comparative Example 2)

The donor concentration of a silicon single crystal substrate was controlled under the same conditions as in Example 2, except that the oxygen and carbon concentrations of the prepared silicon single crystal substrate (control-target substrate) were not adjusted based on the correlation acquired using test silicon single crystal substrates.

In this event, the prepared silicon single crystal substrate had been produced from a silicon single crystal grown by the MCZ method. The oxygen concentration was adjusted to 5.2×10¹⁷ atoms/cm³, and the carbon concentration was adjusted to 1.1×10¹⁵ atoms/cm³.

The prepared silicon single crystal substrate was irradiated with protons and heated under the same conditions as in Example 2. The integrated donor increment was measured by employing the same procedure as in Example 2. As a result, the integrated donor increment was 1.6×10¹²/cm².

Thus, it was found that although the proton irradiation conditions and the heating conditions in Comparative Example 2 were the same conditions as in Example 2, the value of the integrated donor increment of the silicon single crystal substrate was quite different from the target value of approximately 1.2×10¹²/cm².

Table 5 shows the conditions and results of Example 1 and Comparative Example 1. Table 6 shows the conditions and results of Example 2 and Comparative Example 2.

**[Table 5]**

| | Example 1 | Comparative Example 1 |
|---|---|---|
| Target value of integrated donor increment [/cm²] | about 8×10¹¹ | |
| Test substrate growth method | FZ method | |
| Proton dose [atoms/cm²] in first proton irradiation step | 2×10¹⁴ | |
| Acceleration voltage [MV] in first proton irradiation step | 8 | |
| Proton range [µm] in first proton irradiation step | about 15 | |
| Absorber material | aluminum foils | |
| Total absorber thickness [µm] | about 410 | |
| First heating temperature [°C] | 350 | |
| Heating time [min.] | 60 | |
| Atmosphere | nitrogen atmosphere | |
| Measurement of depth direction distribution of donor concentration | same as Experimental Examples (spreading resistance measurement method (SR method)) | |
| Correlation | almost same as FIG. 8 | not based |
| Control-target substrate raw-material silicon | silicon single crystal ingot grown by CZ method | polycrystalline silicon ingot |
| Control-target substrate growth method | FZ method | FZ method |
| Oxygen concentration [atoms/cm³] | 1.2×10¹⁶ | 2.0×10¹⁵ |
| Carbon concentration [atoms/cm³] | 1.0×10¹⁵ | 9.8×10¹⁴ |
| Proton dose [atoms/cm²] in second proton irradiation step | 2×10¹⁴ | |
| Acceleration voltage [MV] in second proton irradiation step | 8 | |
| Proton range [µm] in second proton irradiation step | about 15 | |
| Absorber material | aluminum foils | |
| Total absorber thickness [µm] | about 410 | |
| Second heating temperature [°C] | 350 | |
| Heating time [min.] | 60 | |
| Atmosphere | nitrogen atmosphere | |
| Integrated donor increment [/cm²] | 8.4×10¹¹ | 1.2×10¹² |

**[Table 6]**

| | Example 2 | Comparative Example 2 |
|---|---|---|
| Target value of integrated donor increment [/cm²] | about 1.2×10¹² | |
| Test substrate growth method | FZ, MCZ methods | |
| Proton dose [atoms/cm²] in first proton irradiation step | 2×10¹⁴ | |
| Acceleration voltage [MV] in first proton irradiation step | 8 | |
| Proton range [µm] in first proton irradiation step | about 15 | |
| Absorber material | aluminum foils | |
| Total absorber thickness [µm] | about 410 | |
| First heating temperature [°C] | 450 | |
| Heating time [min.] | 60 | |
| Atmosphere | nitrogen atmosphere | |
| Measurement of depth direction distribution of donor concentration | same as Experimental Examples (spreading resistance measurement method (SR method)) | |
| Correlation | almost same as FIG. 12 | not based |
| Control-target substrate raw-material silicon | polycrystalline silicon | polycrystalline silicon |
| Control-target substrate growth method | MCZ method | MCZ method |
| Oxygen concentration [atoms/cm³] | 1.9×10¹⁷ | 5.2×10¹⁷ |
| Carbon concentration [atoms/cm³] | 6.7×10¹⁴ | 1.1×10¹⁵ |
| Proton dose [atoms/cm²] in second proton irradiation step | 2×10¹⁴ | |
| Acceleration voltage [MV] in second proton irradiation step | 8 | |
| Proton range [µm] in second proton irradiation step | about 15 | |
| Absorber material | aluminum foils | |
| Total absorber thickness [µm] | about 410 | |
| Second heating temperature [°C] | 450 | |
| Heating time [min.] | 60 | |
| Atmosphere | nitrogen atmosphere | |
| Integrated donor increment | 1.2×10¹² | 1.6×10¹² |

Since Comparative Examples 1 and 2 were not based on a correlation between integrated donor increments and products of oxygen and carbon concentrations in test silicon substrates, the values of the integrated donor increments of the control-target substrates were quite different from the target values.

In contrast, in Examples 1 and 2, which are Examples of the inventive method for controlling a donor concentration in a silicon single crystal substrate, the oxygen and carbon concentrations of the silicon single crystal substrates (control-target substrates) prepared in the preparation step were adjusted based on the correlations between the integrated donor increments and the products of the oxygen and carbon concentrations in the test silicon substrates such that the integrated donor increments of the silicon single crystal substrates (control-target substrates) would reach the target values after the second heat treatment step. Thereby, the donor concentration variation attributable to silicon single crystal substrates was successfully reduced, and the donor concentration was successfully controlled with high precision.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention.

## Claims

1. A method for controlling a donor concentration in a silicon single crystal substrate by performing:
a preparation step of preparing a silicon single crystal substrate whose donor concentration is to be controlled;
a second proton irradiation step of irradiating with protons the prepared silicon single crystal substrate; and
a second heat treatment step of heating the silicon single crystal substrate after the second proton irradiation step, so that the donor concentration is controlled,
wherein the method comprises:
a first proton irradiation step of irradiating with protons a plurality of test silicon single crystal substrates having different oxygen concentrations and carbon concentrations, in advance before performing the preparation step;
a first heat treatment step of heating the plurality of test silicon substrates after the first proton irradiation step;
a measurement step of measuring donor increments attained in the plurality of test silicon single crystal substrates after the first heat treatment step; and
a correlation acquisition step of acquiring a correlation between the measured donor increments and products of the oxygen concentrations and the carbon concentrations of the plurality of test silicon substrates,
wherein an oxygen concentration and a carbon concentration in the silicon single crystal substrate whose donor concentration is to be controlled and which is prepared in the preparation step are adjusted based on the acquired correlation such that the donor concentration in the silicon single crystal substrate whose donor concentration is to be controlled reaches a target value after the second heat treatment step.

2. The method for controlling a donor concentration in a silicon single crystal substrate according to claim 1, wherein
a product of the oxygen concentration and the carbon concentration in the silicon single crystal substrate whose donor concentration is to be controlled and which is prepared in the preparation step is 1×10³² [(atoms/cm³)]² or less, and
the second heat treatment step is performed at a heating temperature of 300 to 400°C.

3. The method for controlling a donor concentration in a silicon single crystal substrate according to claim 1, wherein
a product of the oxygen concentration and the carbon concentration in the silicon single crystal substrate whose donor concentration is to be controlled and which is prepared in the preparation step is 2×10³³ [(atoms/cm³)]² or less, and
the second heat treatment step is performed at a heating temperature of 425 to 500°C.
